# EUROPEAN PATENT SPECIFICATION

(11) **EP 3 276 631 B1**
(45) Date of publication and mention of the grant of the patent: **30.06.2021**
(21) Application number: 17182865.0
(22) Date of filing: 24.07.2017
(51) Int. Cl.: H01B 1/02, B32B 15/14, B32B 5/02, B32B 5/26, B64D 45/02

(54) **METAL-MODIFIED, PLASMA-TREATED THERMOPLASTICS FOR IMPROVED ELECTRICAL PERFORMANCE**
METALLMODIFIZIERTE PLASMABEHANDELTE THERMOPLASTE ZUR VERBESSERUNG DER ELEKTRISCHEN LEISTUNG
THERMOPLASTIQUES MODIFIÉS PAR UN MÉTAL ET TRAITÉS AU PLASMA POUR AMÉLIORER LES PERFORMANCES ÉLECTRIQUES

(30) Priority: 26.07.2016 US 201615219963
(43) Date of publication of application: 31.01.2018
(73) Proprietor: The Boeing Company, Chicago, IL 60606-2016 (US)
(72) Inventor: TSOTSIS, Thomas K, Chicago, IL 60606-2016 (US); BELCHER, Marcus A, Chicago, IL 60606-2016 (US)
(74) Representative: Boult Wade Tennant LLP

(56) References cited:
- EP-A1- 2 660 048
- WO-A1-95/20479
- WO-A1-2011/075344
- WO-A1-2013/030658
- US-A1- 2011 262 699

## Description

### Field

The present disclosure relates generally to thermoplastics, and more specifically to thermoplastics modified to improve electrical characteristics.

### Background

Components of vehicles and machines, such as aircraft, are designed to tolerate a variety of harsh operational conditions. In some cases, reinforced composite materials are utilized in many aircraft assemblies and systems because the composite materials show resilience against extreme electric-charging such as a lightning strike. The composite materials used in aircraft are typically made to be conductive along the material surface. As a result, the majority of electric current and charging is dissipated along the conductive surface of the composite material. However, some composite materials include interior thermoplastic particles, layers, or other such internal materials, which are not conductive. In some cases, the thermoplastic layers retain and build-up unwanted electric current and/or charge following electric charging.

WO 95/20479, in accordance with its abstract, states a method of manufacturing a composite laminate having a plurality of UD layers, i.e., layers of matrix material reinforced with unidirectionally oriented fibres, and at least one inner metal layer, i.e., a metal layer that does not form an outer surface of the laminate, the layers being arranged so as to give a balanced and symmetric laminate. The method comprises passing through a laminating zone, preferably a double-belt press, unidirectionally oriented (UD) fibres provided with not yet consolidated matrix material and consolidating the matrix material. In a first step a non-flowing sandwich laminate of at least three layers is formed, the at least three layers being UD and metal layers, the sandwich laminate being formed by passing UD fibres provided with not yet consolidated matrix material through the laminating zone together with metal foil, and in a second step the non-flowing sandwich laminate is provided on its outer surfaces with UD layers, with additional UD layers optionally being added in subsequent steps.

US 2011/262699, in accordance with its abstract, states a multilayer radiant-barrier structure formed on one or both sides of a substrate that can be attached to an insulating layer to produce a reflective insulating material. It is described that the metallized layer is protected from environmental degradation without interfering with flammability properties that are critical for radiant and reflective insulation materials used in housing applications. It is also described that the metal layer is modified to insulate enclosures without blocking cellular communications and the protective functional layer in modified to minimize emissivity, create a hydrophobic and/or oleophobic surface, and/or prevent mold, fungi and bacteria growth. Solutions are provided to solve occupational-hazard problems associated with the use of these materials in enclosures that include power wires.

EP 2 660 048, in accordance with its abstract, states a structure of composite material, comprising a continuous first layer of composite material, a second layer of viscoelastic material, and a continuous impact-protection third layer. The first layer is formed by structural components in the form of a matrix and fibers. The second layer of viscoelastic material is added on top of the first layer and said second layer can be continuous or non-continuous. If a non-continuous second layer is used, elongate, circular or square cavities are arranged inside said layer. Optionally, reinforcements comprising carbon nanofibers or nanotubes are provided in either of the first and second layers. The third layer of impact-protection material is added in a continuous manner on top of the second layer, said third layer forming the outermost layer of the composite material. In addition, this third layer is electrically conductive. It is described that the composite material has noise attenuation, impact resistance and electric conductivity properties.

WO2011/075344, in accordance with its abstract, states metal- or metal alloy-coated sheet materials (hereinafter, "metal-coated sheet material") including, but not limited to, fabrics and veils which have a metal content of between one (1) and fifty (50) grams per square meter (gsm). The metal-coated sheet materials may be used as-is or in conjunction with prepregs, adhesives or surfacing films to provide lightning strike protection (LSP) and/or bulk conductivity, among other properties, to the resultant composite article. In one embodiment, the metal-coated sheet material is impregnated with a resin. According to some embodiments, a metal is applied to one or two sides of the fabric or veil by a physical vapor deposition coating process. It is described that the resultant metal-coated fabric or veil may be used as a carrier in surfacing films to impart surface conductivity; may be used as a carrier in adhesives to form conductive adhesive-bonded joints; may be interleaved (one or more metal-coated veils) between layers of prepreg to impart surface and/or bulk conductivity as well as toughness; or may be used to fabricate composite articles.

WO 2013/030658, in accordance with its abstract, states a thermal insulation structure including a fabric layer and a dual-layer infrared radiation reflective metal coating disposed on a surface of the fabric layer. The dual- layer infrared radiation reflective metal coating includes a first coating layer directly applied on to the surface of the fabric layer, and, a second coating layer applied on to the first coating layer.

Therefore, a thermoplastic layer is needed with increased conductivity that is capable of dissipating electric current and charge away from the thermoplastic layers following electric charging, while maintaining the structural strength and improved impact resistance provided by the composite material.

### Summary

In accordance with one aspect of the present disclosure, a method of imparting electrical conductivity on an interlayer material is disclosed. The method includes forming an interlayer from at least one layer of fabric of thermoplastic fibers. Moreover, the method further includes, treating a surface of the interlayer material using an atmospheric-pressure plasma such that the surface of the interlayer material undergoes a surface activation. Additionally, the method includes depositing a layer of conductive material on the surface of the interlayer material, such that the conductive material increases a conductivity of the interlayer material, the layer of conductive material comprising multiple different metal layers.

In accordance with another aspect of the present disclosure, a method of manufacturing a composite material incorporating an interlayer having electrical conductivity is disclosed. The method includes forming a plurality of interlayers from an interlayer material and treating each interlayer of the plurality of interlayers with an atmospheric-pressure plasma such that a surface of each interlayer of the plurality of interlayers undergoes a surface-activation. Moreover, the method further includes depositing a conductive layer on the surface of each interlayer of the plurality of interlayers such that the conductive layer increases a conductivity of the plurality of interlayers, the conductive layer comprising multiple different metal layers. Additionally, the method includes forming a plurality of reinforcing layers from fibers of reinforcing material and disposing the plurality of interlayers each having the conductive layer on the surface alternately between the plurality of reinforcing layers. Furthermore, the method includes coupling the plurality of reinforcing layers and the plurality of interlayers together. The method further includes infusing the plurality of reinforcing layers and the plurality of interlayers with a matrix material, and curing the matrix material such that the conductivity of the plurality of interlayers improves the electrical conductivity of the composite material.

In accordance with yet another aspect of the present disclosure, a composite material having electrical conductivity is disclosed. The composite material includes a plurality of interlayers each formed from a layer of fabric of thermoplastic fibers and a surface of each interlayer of the plurality of interlayers being treated with an atmospheric-pressure plasma such that the surface of each interlayer of the plurality of interlayers undergoes a surface-activation. Moreover, the composite material further includes a conductive layer being deposited on the surface of each interlayer of the plurality of interlayers such that the conductive layer increases a conductivity of each interlayer of the plurality of interlayers, the conductive layer comprising multiple different metal layers. A plurality of reinforcing layers being formed from fibers of reinforcing material, wherein each interlayer of the plurality of interlayers having the conductive layer on the surface is alternately disposed between the plurality of reinforcing layers, wherein the plurality of reinforcing layers are coupled together with the plurality of interlayers . The composite further includes, a matrix material being infused into the plurality of reinforcing layers and the plurality of interlayers, wherein the matrix material is cured such that the conductivity of the plurality of interlayers improves the electrical conductivity of the composite material.

The features, functions, and advantages disclosed herein can be achieved independently in various embodiments or may be combined in yet other embodiments, the details of which may be better appreciated with reference to the following description and drawings.

### Brief Description of the Drawings

FIG. 1 is a perspective view of an exemplary vehicle constructed in accordance with the present disclosure;
FIG. 2 is a sectional view of an exemplary composite material in accordance with one embodiment of the present disclosure;
FIG. 3A is a sectional view illustrating one exemplary embodiment of the interlayer fibers of the present disclosure;
FIG. 3B is a sectional view of another exemplary embodiment of the interlayer fibers of the present disclosure;
FIG. 3C is a sectional view of another exemplary embodiment of the interlayer fibers of the present disclosure;
FIG. 4 is a perspective view of an exemplary composite material in accordance with one embodiment of the present disclosure;
FIG. 5 is a sectional view of a composite laminated structure formed with a preform mold in accordance with one embodiment of the present disclosure;
FIG. 6 is a schematic view of the interlayer material being treated in accordance with one embodiment of the present disclosure;
FIG. 7 is a schematic view of the interlayer material being treated in accordance with another embodiment of the present disclosure;
FIG. 8 is flow diagram illustrating a method for treating the interlayer in accordance with an embodiment of the present disclosure; and
FIG. 9 is a flow diagram illustrating a method for forming a composite laminated structure incorporated the treated interlayer of FIG. 8 in accordance with an embodiment of the present disclosure.

It should be understood that the drawings are not necessarily to scale, and that the disclosed embodiments are illustrated diagrammatically, schematically, and in some cases in partial views. In certain instances, details which are not necessary for an understanding of the disclosed methods and apparatuses or which render other details difficult to perceive may have been omitted. It should be further understood that the following detailed description is merely exemplary and not intended to be limiting in its application or uses. As such, although the present disclosure is for purposes of explanatory convenience only depicted and described in illustrative embodiments, the disclosure may be implemented in numerous other embodiments, and within various systems and environments not shown or described herein.

### Detailed Description

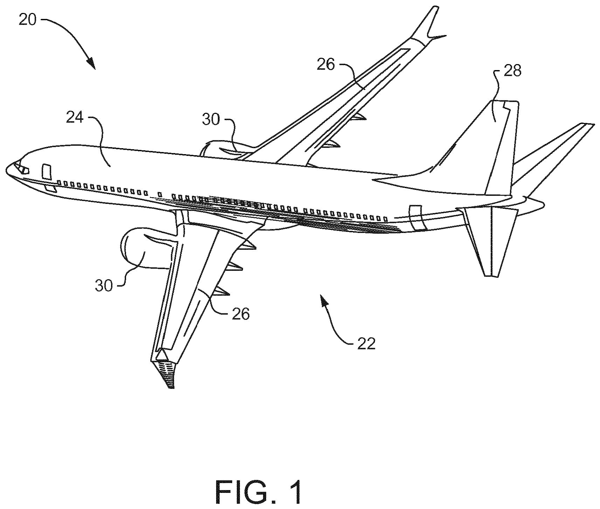

Referring to FIG. 1, a vehicle 20, is illustrated. While one non-limiting example of the vehicle 20 is that of an aircraft, it will be appreciated that the present disclosure applies to other types of vehicles and machines as well, such as but not limited to, marine vessels, construction equipment, and power generators. In some embodiments, the vehicle 20, or aircraft, is configured with an airframe 22, including a fuselage 24, a plurality of wings 26, a tail section 28, and other such assemblies and systems of the vehicle 20. Additionally, one or more propulsion units 30 are coupled to the underside of each of the wings 26 in order to propel the vehicle 20 in a direction of travel. However, other attachment locations and configurations of the propulsion units 30 are possible. Furthermore, each of the wings 26 are attached along an approximately central portion of the fuselage 24, and the wings 26 are swept back towards the tail section 28 or aft portion of the vehicle 20. Moreover, in some embodiments, the assemblies, systems and other components of the vehicle 20, are exposed to environmental conditions such as but not limited to, extreme temperature variations, high and/or low humidity, electrical charging and/or discharging, mechanical vibration, airborne particles, debris, and other such conditions encountered during operation. As a result, in some embodiments, the materials and other components used to fabricate the fuselage 24, wings 26, tail section 28, propulsion units 30 and other such assemblies and systems, are configured such that they are capable of withstanding thermal expansion and/or contraction, increased moisture levels, electrical charging, mechanical shocks, and other such conditions.

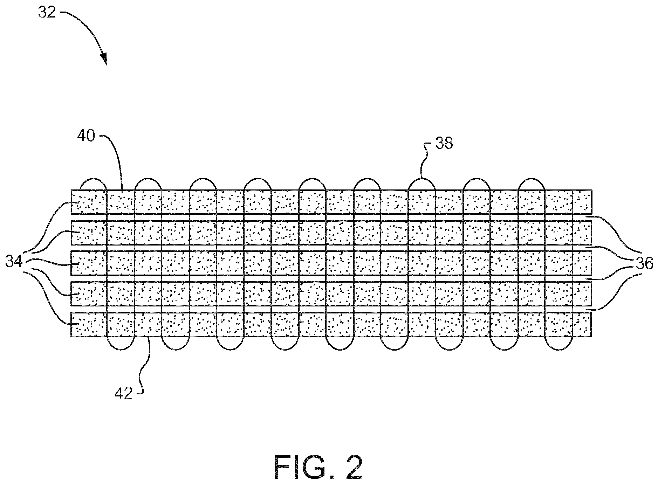

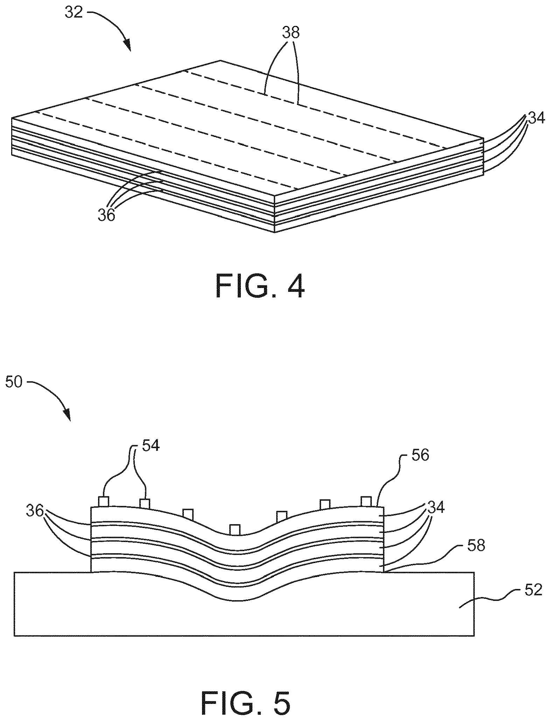

Moving on to FIGS. 2 and 4, one embodiment of a composite material 32 used to fabricate, or otherwise construct, assemblies and systems of the vehicle 20 is illustrated. In one non-limiting example, the composite material 32 is a fabric built up from a plurality of alternating layers composed of one or more reinforcing layers 34 and one or more interlayers 36. In an embodiment, the reinforcing layers 34 and the interlayers 36 are stacked or otherwise arranged such that one layer of the interlayer 36 is positioned (i.e., sandwiched) between two of the reinforcing layers 34. For example, the composite material 32 is formed as a stack of material starting with a reinforcing layer 34 placed at the bottom. An interlayer 36 is placed on top of the bottom reinforcing layer 34 and another reinforcing layer 34 is placed on top of the interlayer 36. As a result, some embodiments repeat this stacking pattern to create the desired thickness of the composite material 32. Moreover, in some embodiments, following the build-up of the composite material 32, a stitching 38, or other fastening mechanism, is used to couple, or otherwise connect and hold the alternating reinforcing layers 34 and interlayers 36 in place.

In some embodiments, the reinforcing layers 34 are composed of carbon-fiber, glass-fiber, mineral-fiber, or other such reinforcing material. Moreover, in one non-limiting example, the reinforcing layers 34 are formed such that a plurality of carbon-fibers, glass-fibers, mineral-fibers, or other such fibers are arranged to create layers of fibers having a unidirectional pattern. Such an arrangement of the fibers provides a tough, durable and lightweight structural material for use in fiber reinforced composite materials and other such reinforcing materials.

Moreover, the interlayers 36 are formed from a fabric of one or more different type of continuous fibers, and in one non-limiting example, the interlayers 36 are formed from a layer of non-woven fabric of thermoplastic fibers having at least two different types of thermoplastic fibers. In some embodiments, the interlayers 36 are non-woven layers of material such as but not limited to, spunbonded fabric, spunlaced fabric, mesh fabric, or other such fabric. For example, a spunbonded fabric is produced from continuous filaments or fibers that are continuously spun and thermally bonded to form a layer of non-woven fabric. Alternatively, a spunlaced fabric is prepared from continuous filaments or fibers which are continuously spun and bonded mechanically.

In some exemplary embodiments, the interlayers 36 are formed using the above mentioned methods from one or more different types of thermoplastic filaments or fibers such as but not limited to, polyamide, polyimide, polyamide-imide, polyester, polybutadiene, polyurethane, polypropylene, polyetherimide, polysulfone, polyethersulfone, polyphenylsulfone, polyphenylene sulfide, polyaryletherketone, polyetherketoneketone, polyetheretherketone, polyacrylamide, polyketone, polyphthalamide, polyphenylene ether, polybutylene terephthalate, polyethylene terephthalate, polyester-polyarylate (e.g., Vectran®).

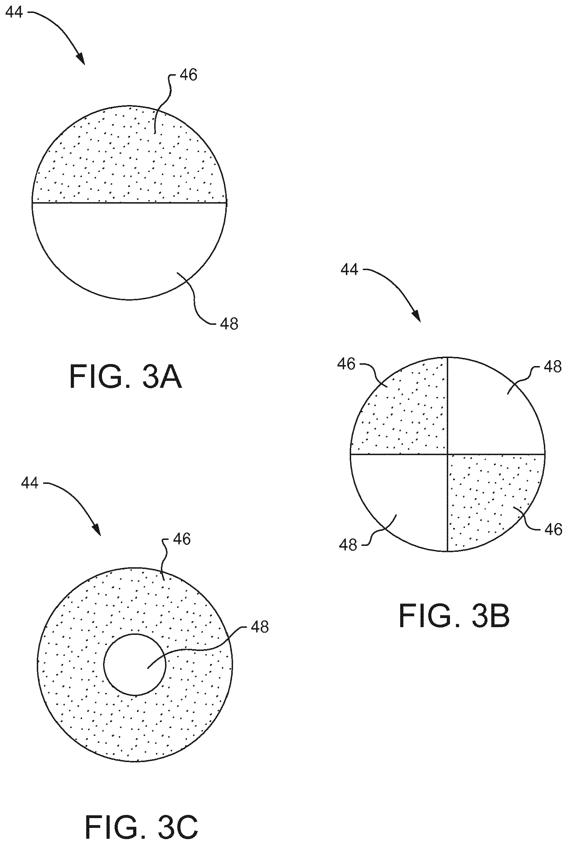

In some embodiments, the interlayers 36 are made up of filaments or fibers which incorporate two or more different thermoplastic materials. FIGS. 3A-C illustrate several different non-limiting configurations of a thermoplastic fiber 44 formed using two different thermoplastic materials. While FIGS. 3A-C show thermoplastic fibers 44 which are constructed of two different materials, other embodiments of thermoplastic fibers 44 composed of a different number of thermoplastic materials is possible. FIG. 3A provides one exemplary cross-sectional illustration of the thermoplastic fiber 44 being made from substantially equal amounts of a first material 46 and a second material 48. In such a configuration, the first material 46 and the second material 48 are extruded, or otherwise forced through a fixture with two openings to produce the thermoplastic fiber 44 such that the first material 46 is stacked on top of the second material 48. Moreover, FIG. 3B illustrates another non-limiting example of the thermoplastic fiber 44 being formed by the extrusion of the first material 46 and the second material 48 through a fixture with four openings. As a result, the thermoplastic fiber 44 illustrated in FIG. 3B is composed of alternating regions of first and second materials 46, 48. In an additional embodiment illustrated in FIG. 3C, the thermoplastic fiber 44 is formed using a coaxial arrangement of the first and second materials 46, 48. For example, the first material 46 defines a sheath region and the second material 48 defines a core region of the thermoplastic fiber 44. The thermoplastic fiber 44 configurations illustrated in FIGS. 3A-3C show the fibers having a circular or thread-like cross-section. It will be appreciated that the thermoplastic fibers 44 are capable of being extruded, or otherwise formed into other shapes and structures, such as but not limited to, rectangular shaped ribbons, oval-shaped filaments or fibers, or any other suitable shape or structure.

Referring now to FIG. 5, and with continued reference to FIGS. 2-4, one non-limiting example of the stack of composite material 32 being formed into a fiber-reinforced composite laminate structure 50 is illustrated. In some embodiments, the composite laminate structure 50 is formed by vacuum-assisted resin transfer molding (i.e., preform molding), however other molding processes are possible. In vacuum-assisted resin transfer molding, the composite material 32 is positioned onto a mold 52 or other such template, which is used to impart a shape to the composite material 32. As a result, depending on the intended application, different molds 52 are used to size, shape, and otherwise form the composite laminate structure 50. Moreover, a matrix material, such as but not limited to a resin, an epoxy, or other such hardening material, is introduced into the mold 52, and the matrix material infuses through the composite material 32 being supported by the mold 52. In some embodiments, the matrix material permeates through the entire composite material 32 and saturates the reinforcing layers 34 and the interlayers 36 which are disposed in between the reinforcing layers 34. Alternatively, in some embodiments the matrix material is directed or controlled to permeate through a portion of composite material 32. Moreover, the interlayers 36 are configured to facilitate the permeation of the matrix material through the interlayers 36 to ensure that all of the layers of the composite material 32 are sufficiently saturated (i.e., wet-out) with the matrix material such that the matrix material covers the interlayers 36 to maximize the contact area between the interlayers 36 and the reinforcing layers 34. Furthermore, the stitching 38 inserted between the reinforcing layers 34 and the interlayers 36 helps to hold the stack of composite material 32 in place during the infusion of the matrix material.

While one non-limiting example of forming the composite laminate structure 50, such as but not limited above, preform molding, is discussed above, it should be known that other methods are possible. For example, in another embodiment, the interlayers 36 are alternately disposed in between the reinforcing layers 34 to build-up the stack of composite material 32. Furthermore, prior to placing the composite material 32 onto the mold surface the composite material 32 is pre-impregnated (i.e., prepreg), or otherwise infused, with matrix material, such as resin, epoxy, or other such hardening material. In some embodiments, the composite material 32 prepreg is partially cured following the infusion with matrix material. In some cases, this partial curing allows for easier handling of the composite material 32 and matrix material. Moreover, when the composite laminate structure 50 is ready to be formed the composite material 32, with the pre-impregnated matrix material, is placed onto the mold surface and fully cured at an elevated temperature and/or pressure. As a result, the composite laminate structure 50 is formed and shaped according to the size and shape of the mold surface.

In some embodiments, either during or after the infusion of the matrix material, the mold 52 holding the stack of composite material 32 is enclosed within a vacuum chamber, or other pressure controlled environment, to further facilitate the transport and infusion of the matrix material throughout the stack of composite material 32. Moreover, in some embodiments, after the stack of composite material 32 is saturated with the matrix material, the mold 52 is heated to a temperature which cures or otherwise hardens the matrix material. As a result, as the matrix material begins to harden reinforcing layers 34 and the interlayers 36 are bound together. When the matrix material is fully cured, the composite laminate structure 50 will be formed into the shape of the supporting mold 52. In some embodiments, during the curing of the matrix material the temperature is steadily increased such that during the initial phase of the temperature increase the matrix material continues to flow in between the reinforcing layers 34 and the interlayers 36. Moreover, as the temperature continues to rise the matrix material begins to at least partially solidify and once the cure temperature is reached, the mold 52 and the stack of composite material 32 is held at the cure temperature for a pre-determined period of time. In one non-limiting example, the cure temperature of the matrix material is between a range of 150° to 200° C and the cure time is between 1 to 6 hours. However, the cure temperature and time will vary depending on the stack of composite material 32 and the matrix material used to form the composite laminate structure 50.

Additionally, it should be noted that generally, the gel temperature of the matrix material will be at or below the melting temperature of the reinforcing layers 34 and interlayers 36. As such, the melting temperature of the reinforcing layers 34 and interlayers is above 200° C, however other melting temperatures are possible. Moreover, in some embodiments, the gel and cure temperatures of the matrix material will be above the glass-transition temperature and below the melting temperature of the reinforcing layers 34 and the interlayers 36. In such embodiments, a cure temperature between the glass-transition temperature and the melting temperature will facilitate the shaping and molding of the reinforcing layers 34 and the interlayers 36 without changing the structural integrity of the materials. Alternatively, it is possible that some embodiments will use a cure temperature which is slightly above the melting temperature of the reinforcing layers 34 and the interlayers 36 to facilitate an interdiffusion between the matrix material and the reinforcing layers 34 and/or interlayers 36.

Once the matrix material is fully cured, the formation of the composite laminate structure 50 is complete. Moreover, the finished composite laminate structure 50 will take the form of the mold 52 which held the composite material 32 and matrix material during molding. Differently shaped molds 52 are used depending on the desired shape for the composite laminate structure 50. As a result, a plurality of differently shaped molds 52 are used to produce differently shaped composite laminate structures 50 which are used in various assemblies and systems of the vehicle 20 shown in FIG. 1.

As further shown in FIG. 5, with continued reference to FIGS. 2-4, in some cases the reinforcing layers, 34, the interlayers 36, the stitching 38 and the matrix material are arranged to produce a composite laminate structure 50 that exhibits certain properties. For example, in some cases the composite laminate structure 50 is incorporated into structural assemblies and systems which require certain structural properties, such as but not limited to, high compressive strength, high tensile strength, increased fracture toughness, and other such properties. Moreover, in some embodiments the addition of the interlayer 36 provides an improved impact resistance to composite laminate structure 50. Additionally, the composite laminate structure 50 will generally be required to exhibit good chemical resistance to solvents including but not limited to, aviation fuel, hydraulic fluid, brake fluid, ketones, water, and other chemicals the composite laminate structure 50 will come into contact with. Moreover, the composite laminate structure 50 must be able to withstand a host of environmental conditions it will be exposed to during use. For example, in some embodiments, the composite laminate structure 50 is exposed to extreme temperature variations, high and/or low humidity, electrical charging and/or discharging, mechanical vibration and shock, airborne particles and debris, and other such environmental conditions encountered during use and/or operation.

Generally, the thermoplastic material which forms the interlayer 36 has inherent electrically insulating properties. As a result, when the interlayer is exposed to electrical current or charge some embodiments of the interlayer 36 will behave like an electrical storage device (i.e., a capacitor). In some situations, the composite laminate structures 50 formed with the reinforcing layers 34 and the interlayers 36, are capable of holding onto or storing an electrical charge for a prolonged period of time. During operation, the vehicle 20 in FIG. 1, is exposed to several potential electrical events, such as but not limited to a lightning strike, electromagnetic interference (EMI), electric current, and other such events, which interferes with portions of the vehicle 20. For example, during a lighting strike, the airframe 22 of the vehicle (FIG. 1) is exposed to high electric current which must be dissipated. However, in some embodiments, the composite laminate structures 50, incorporated into a portion of the assemblies and systems of the airframe 22 (FIG. 1), have a high electrical resistance and are unable to dissipate the electric current or charge. As a result, some embodiments of the composite laminate structure 50 include methods and materials to improve the electrical conductivity of the composite laminate structures 50.

Referring to FIG. 5, and in continued reference to FIGS. 2-4, some applications of the composite laminate structures 50 incorporate an conductive mesh 54 formed out of nickel, copper, aluminum, or other such conductive material, to provide a conductive path for the electric current or charge produced by electrical charging and/or discharging. The conductive mesh 54 is configured to provide a conductive pathway which carries the electric current imparted into the composite laminate structure 50 away from the bulk of the structure. In some embodiments, the conductive mesh 54 is positioned along both a top side 56 and a bottom side 58 of the composite laminate structure 50. Alternatively, in some embodiments, the conductive mesh 54 is positioned on only one of the top side 56 or bottom side 58 of the composite laminate structure 50.

The conductive mesh 54 provides adequate conductivity to conduct or otherwise redirect the electric current away from the bulk of the composite laminate structure 50. However, in some embodiments, the interlayers 36 that are incorporated within the composite laminate structure 50 retain the inherently insulating properties of thermoplastic material. As a result, the interlayers 36 are capable of storing residual electrical current or charge which is generated from electrical charging and/or discharging. In one non-limiting example, For example, following an electrical charging and/or discharging event, such as but not limited to a lightning strike, the conductive mesh 54 may not be completely effective in dissipating the electric current from the composite laminate structures 50, and the interlayers 36 retain some of the electric current or charge (i.e., edge-glow).

As a result, in some embodiments, increasing the conductivity of the interlayers 36 will provide improvement against charge build-up on the interlayers 36 and within the composite laminate structures 50. As discussed above, in some embodiments the interlayer 36 is formed from a thermoplastic material, such as but not limited to, polyamide, polyimide, polyamide-imide, polyester, polybutadiene, polyurethane, polypropylene, polyetherimide, polysulfone, polyethersulfone, polyphenylsulfone, polyphenylene sulfide, polyaryletherketone, polyetherketoneketone, polyetheretherketone, polyacrylamide, polyketone, polyphthalamide, polyphenylene ether, polybutylene terephthalate, polyethylene terephthalate, polyester-polyarylate (e.g., Vectran®).However, the thermoplastic material of the interlayer 36 is generally not conductive, and therefore should be modified or otherwise treated to help improve its conductivity and other surface electrical properties.

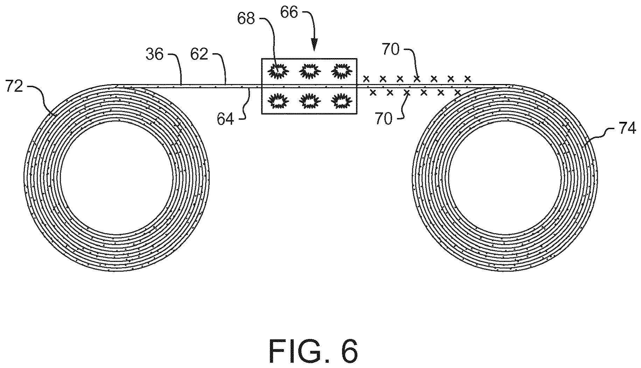

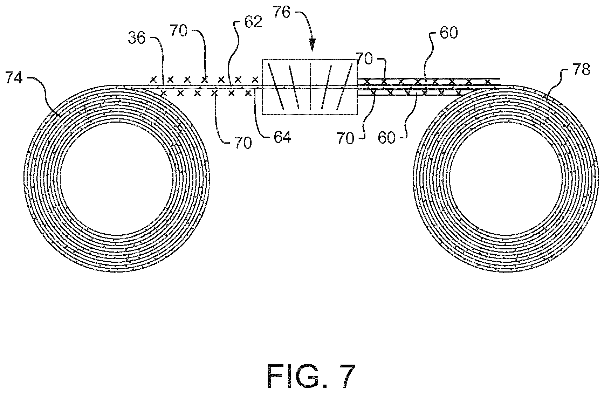

Referring to FIGS. 6 and 7, with continued reference to FIGS. 2-5, one embodiment of the interlayer 36 having increased conductivity is illustrated. In one non-limiting example, the interlayer 36 is made to be more conductive by adding a conductive material 60 onto the surface of the interlayer 36. In some embodiments, the conductive material 60 is deposited as a continuous layer onto the top side 62 and the bottom side 64 of the interlayer 36 surface. Alternatively, in other embodiments, a discontinuous layer (i.e., decorating the surface) of conductive material 60 is deposited onto top and bottom side 62, 64 of the interlayer 36 surface. Furthermore, in other embodiments, the conductive material 60 is deposited on one of the top and bottom sides 62, 64 of the interlayer 36 surface.

In some embodiments, depositing the conductive material 60 on at least one of the top and bottom sides 62, 64 of the interlayer 36 surface will help improve the conductivity of the material. Moreover, in some embodiments, the interlayers 36 in the composite laminate structure 50 are electrically coupled to each other such that the electric current or charge is dissipated from each of the interlayers 36 which are dispersed throughout the composite laminate structure 50. In one non-limiting example, the stitching 38 provides an electric coupling between the interlayers 36 of the composite structure, however, other methods of electrically coupling the interlayers 36 together are possible. As a result, in some embodiments, the enhanced conductive properties of the interlayers 36 facilitates the removal or dissipation of the electric current or charge from the interlayers 36 following electrical charging/discharging.

In some embodiments, the thermoplastic material used to fabricate the interlayer 36 has a lack of robust bonding or attachment sites (i.e., covalent bonding sites) along the top and bottom sides 62, 64 of the interlayer 36 surface. The lack of available bonding sites creates poor adhesion or bonding, and as a result, make it difficult to deposit the conductive material 60 along the top and bottom sides 62, 64 of the interlayer 36. As illustrated in FIG. 6, one embodiment imparts the interlayer 36 is treated with, such as but not limited to, an atmospheric-pressure plasma 66 on the top and bottom sides 62, 64 of interlayer 36 surface to provide improved bonding or attachment sites. For example, the atmospheric-pressure plasma 66 produces ionized gas at atmospheric pressure. The ionized gas is directed towards and bombards or collides with the top and bottom sides 62, 64 of the interlayer 36 surface. Moreover, the atmospheric-pressure plasma 66 is configured to only interact with the surface of the top and bottom sides 62, 64 of the interlayer 36. As a result, adhesion and bonding along the interlayer 36 surface is improved while the bulk properties of interlayer 36 are left unchanged.

In some embodiments, the improvement in the adhesion and bonding to the interlayer 36 surface is caused by an increase in the surface activation energy produced by the treatment with the atmospheric-pressure plasma 66. During treatment, the top and bottom sides 62, 64 of the interlayer 36 are bombarded with the ionized gas 68. This surface bombardment results in producing a plurality of available bonding and attachment sites 70 (i.e., available functional groups on the surface) along the top and bottom sides 62, 64 of the interlayer 36 surface. While the use of atmospheric-pressure plasma 66 is illustrated in FIG. 6, the plurality of bonding and attachment sites 70 can be formed from other types of surface treatment, such as but not limited to, corona discharge, flame plasma, wet chemical treatment and other known surface treatments.

In some embodiments, the interlayer 36 is configured into a pre-treatment roll 72 and a post-treatment roll 74 to help improve throughput of the interlayer 36 as it is fed through the atmospheric-pressure plasma 66. In some embodiments, the atmospheric-pressure plasma 66 is configured to simultaneously treat the top and bottom sides 62, 64 of the interlayer 36, however other configurations are possible. Alternatively, in other embodiments, instead of forming pre-treatment and post-treatment rolls 72, 74, the interlayer 36 is configured in flat sheets or other such configuration, while undergoing treatment with the atmospheric-pressure plasma 66. In one non-limiting example, the atmospheric-pressure plasma 66 is an atmospheric-pressure oxygen plasma, which is comprised of ionized oxygen gas to oxidize the top and bottom sides 62, 64 of the interlayer 36. As a result, the atmospheric-pressure plasma 66 (i.e., atmospheric-pressure oxygen plasma) produces an increased oxygen content along the top and bottom sides 62, 64 of the interlayer 36 which creates and/or increases the available (i.e., unbound) oxygen sites at the bonding and attachment sites 70 along the top and bottom sides 62, 64 of the interlayer 36. In some embodiments, these available oxygen sites are then capable of bonding to or otherwise attaching with the conductive material 60 (FIG. 6) such that the conductive material 60 adheres to the top and bottom sides 62, 64 of the interlayer 36 surface.

In addition to oxygen, the atmospheric-pressure plasma 66 can be formed using other gases or mixture of gases, such as but not limited to, nitrogen, argon, helium, nitrous oxide, ambient air, water vapor, carbon dioxide, methane, ammonia, and other such gases. Moreover, in some embodiments, treatment with the atmospheric-pressure plasma 66 provides other improvements in addition to creating additional bonding or attachment sites 70. For example, in some embodiments, the increase in surface activation energy caused by the atmospheric-pressure plasma 66 can improve the wettability of liquids along the interlayer 36, such as but not limited to the matrix material as it is infused into stack of composite material 32 during the composite laminated structure 50 formation. Moreover, in some embodiments, bombarding the interlayer 36 with atmospheric-pressure plasma 66 helps to remove any contaminants that are present along the top and bottom sides 62, 64 of the interlayer. A cleaner surface will generally show better adhesion and bonding properties. As a result, in some embodiments, the atmospheric-pressure plasma 66 will provide a cleaner surface and an increased number of bonding or attachment sites 70 such that the conductive material 60 (FIG. 7) will have improved adhesion to the top and bottom sides 62, 64 of the interlayer 36.

Referring now to FIG. 7, and with continued reference to FIG. 6, one non-limiting example of depositing the conductive material 60 on the interlayer 36 is illustrated. In some embodiments, following the treatment with the atmospheric-pressure plasma 66, the interlayer 36 is further treated by depositing a layer of conductive material 60 along the top and bottom sides 62, 64 of the interlayer 36. Moreover, in some embodiments, the conductive material 60 is deposited as either a continuous layer or a discontinuous layer along the top and bottom sides 62, 64 of the interlayer 36 surface. As such, the continuous and/or discontinuous layer of conductive material 60 is capable of providing improved electrical surface properties of the interlayer 36, such as but not limited to, an increase in the conductivity, improved EMI shielding, and other such electrical properties. Moreover, in some embodiments, depending on the planned application of the interlayer 36, the conductive layer 60 is deposited on only one of the top or bottom sides 62, 64 of the interlayer 36 surface.

The conductive layer 60 comprises multiple different metal layers, including but not limited to, nickel, copper, silver, or other such metals, which provide improved electrical surface properties of the interlayer 36. Moreover, in some embodiments, to improve the throughput of interlayer 36 treatment, the post-treatment roll 74 of the interlayer 36 is exposed to chemical vapor deposition (CVD) deposition 76 to produce a conductive interlayer roll 78. In some embodiments, CVD deposition 76 is configured to simultaneously deposit the conductive layer 60 on the top and bottom sides 62, 64 of the interlayer 36 as it is fed through CVD deposition 76. Furthermore, while FIG. 7 illustrates the use of CVD deposition 76 for the deposition of the conductive material 60, other deposition methods such as but not limited to, electrodeposition, sputtering, electron beam evaporation, or other such methods are possible. Similarly to curing of the composite laminate structure 50 described above, CVD deposition 76 is generally configured to deposit the conductive material 60 at a temperature which is below the glass transition temperature and/or the melting point of the interlayer 36. In one non-limiting example, the specified melting temperature of the interlayer 36 will be greater than 200° C. However, other melting temperatures are possible depending on which thermoplastic material is used to fabricate the interlayer 36.

In some embodiments, CVD deposition 76 is configured for a specific material deposition amount. For example, as further illustrated in FIG. 7, CVD deposition 76 is capable of depositing a continuous, uniform layer of the conductive material 60 on both the top and bottom sides 62, 64 of the interlayer 36. Moreover, in another embodiment, CVD deposition 76 is capable of being configured to deposit a non-uniform, continuous layer of conductive material 60 such that the thickness of the conductive material 60 is deposited with a varying thickness along the top and bottom sides 62, 64 of the interlayer 36. In still other embodiments, the uniform and non-uniform continuous layer of conductive material 60 is deposited along one of the top or bottom sides 62, 64 of the interlayer 36. Additionally, in some alternative embodiments, a lower amount of conductive material 60 is needed such that a discontinuous layer (i.e., decorating the surface) is deposited along the top and bottom sides 62, 64 of the interlayer 36. Moreover, in some embodiments, the discontinuous layer of conductive material 60 is configured such that it is deposited on one of the top and bottom sides 62, 64 of the interlayer 36.

Alternatively, CVD deposition 76 is capable of depositing a plurality of different conductive layers 60 along the top and bottom sides 62, 64 of the interlayer 36. In some embodiments, the plurality of different conductive layers 60 are deposited directly on top of one another, therefore forming a stack of conductive material 60. For example, a multiple metal layer stack including, but not limited to, nickel, copper, silver, or other such metal is deposited along the top and bottom sides 62, 64 of the interlayer 36. As described above, CVD deposition 76 is capable of being used for depositing the plurality of different layers of metal along the top and bottom sides 62, 64 of the interlayer 36. In some embodiments, the interlayer 36 will be fed through CVD deposition 76 multiple times, with each pass depositing a different metal layer. Moreover, in some embodiments the plurality of different metals forming the conductive layer 60 can be deposited on both the top and bottom sides 62, 64 of the interlayer 36, deposited on one of the top and bottom sides 62, 64 of the interlayer 36, deposited as continuous uniformly and/or non-uniformly thick layers of conductive material. Alternatively, the plurality of different metals is deposited to form discontinuous uniformly, and/or non-uniformly thick layers of conductive material, however other deposition variations are possible depending on the planned interlayer 36 application. The deposition of multiple different metal layers to form the conductive layer 60 to improve the electrical surface properties of the interlayer 36 such as, but not limited, to increased conductivity, improved EMI shielding, and other such electrical properties. In one non-limiting example, the deposition of different metal layers provides a broader spectrum of electromagnetic frequencies which are dampened or otherwise blocked by the conductive layer 60 deposited along the top and bottom sides 62, 64 of the interlayer 36.

### Industrial Applicability

In general, the foregoing disclosure finds utility in various applications such as in transportation, mining, construction, industrial, and power generation machines and/or equipment. In particular, the disclosed composite material incorporating a modified thermoplastic layer is applied to vehicles and machines such as aircraft, hauling machines, marine vessels, power generators, and the like. Through the novel teachings outlined above, the composite laminate structure 50 is fabricated using a plurality of reinforcing layers 34 and interlayers 36. Moreover, in some embodiments, the interlayers 36 are modified to provide enhanced electrical surface properties, such as but not limited to increased conductivity, improved EMI shielding, and other such electrical properties. As a result, in some embodiments, the interlayers 36 with enhanced electrical surface properties provide improved dissipation of electrical current or charging of the composite laminate structure 50 while also maintaining improved impact resistance to the composite laminate structure 50.

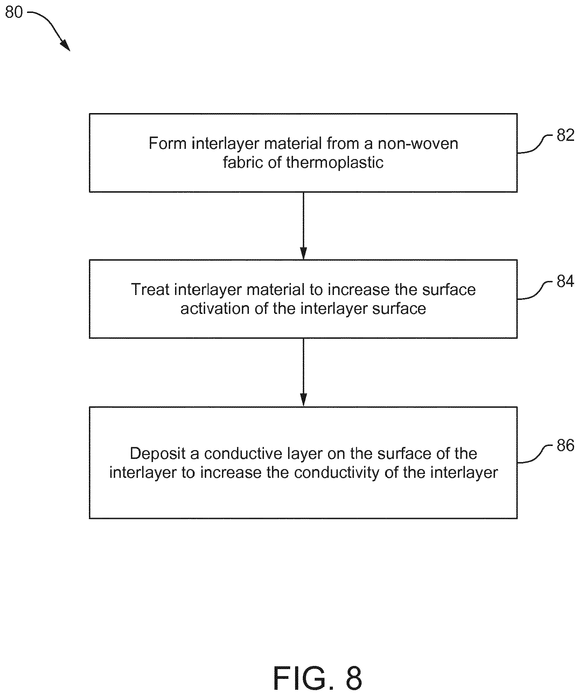

FIG. 8, with continued reference to FIGS. 1-7, illustrates an exemplary method 80 of modifying the interlayer 36 to impart improved electrical surface properties. In a first block 82 of method 80, the interlayer 36 is formed from a thermoplastic material, such as but not limited to polyamide, polyimide, polyamide-imide, polyester, polybutadiene, polyurethane, polypropylene, polyetherimide, polysulfone, polyethersulfone, polyphenylsulfone, polyphenylene sulfide, polyaryletherketone, polyetherketoneketone, polyetheretherketone, polyacrylamide, polyketone, polyphthalamide, polyphenylene ether, polybutylene terephthalate, polyethylene terephthalate, polyester-polyarylate (e.g., Vectran®).Moreover, in some embodiments, the interlayer 36 is configured to form a non-woven fabric layer of thermoplastic material, however other configurations of the interlayer 36 are possible.

In a next block 84, the interlayer 36 is treated such that the top and bottom sides 62, 64 of the interlayer 36 are modified to create a plurality of bonding or attachment sites 70. In some embodiments, the interlayer 36 is modified or otherwise treated using an atmospheric-pressure plasma 66 which bombards the top and bottom sides 62, 64 of the interlayer 36. Moreover, in one non-limiting example, the atmospheric-pressure plasma 66 is an atmospheric-pressure oxygen plasma and uses ionized oxygen gas to create the plasma that treats the surface of the interlayer 36. In some cases, the atmospheric-pressure oxygen plasma helps to increase the surface energy along the top and bottom sides 62, 64 of the interlayer 36, as well as provide a plurality of bonding and/or attachment sites 70. In a next block 86 of the method 80, a conductive layer 60 is deposited along the top and bottom sides 62, 64 of the interlayer 36. In some embodiments, the increased surface energy and plurality of bonding and attachment sites 70 produced by the atmospheric-pressure plasma 66 enhance the adhesion of the conductive layer 60 to the top and bottom sides 62, 64 of the interlayer 36. Moreover, in some embodiments, the addition of the conductive layer 60 to the interlayer 36 provides improved electrical surface properties, such as but not limited to increased conductivity and improved EMI shielding.

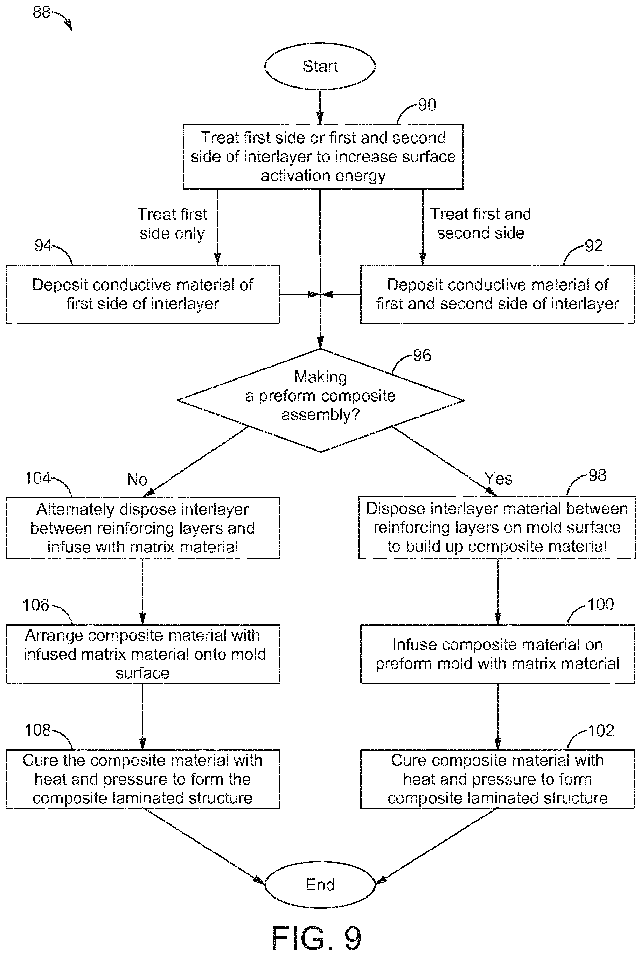

FIG. 9, with continued reference to FIGS. 1-8, illustrates a method 88 for forming a composite laminate structure 50 which incorporates the interlayer 36 having improved electrical surface properties. In a first block 90, the interlayer 36 is treated to provide enhanced and improved electrical properties. In one embodiment, the top and bottom sides 62, 64 of the interlayer 36 are treated to improve the adhesion between the interlayer 36 and a conductive material 60 which is deposited on the top and/or bottom sides 62, 64 of the interlayer 36. In some embodiments, following treatment of the interlayer 36, a determination is made whether to deposit the conductive material 60 on one of or on both the top and bottom sides 62, 64 of the interlayer 36. If the determination is made to deposit the conductive material 60 on both the top and bottom side 62, 64 is made, then in a next block 92 the conductive material 60 is subsequently deposited on the top and bottom sides 62, 64 of the interlayer 36. Alternatively, if the determination to deposit the conductive material 60 on only one of the top and bottom sides 62, 64 of the interlayer is made, then in a next block 94 the conductive material 60 is deposited along the top or bottom sides 62, 64 of the interlayer.

Following the deposition of the conductive material 60, in a next block 96, it is determined whether the interlayer 36 will be used in a preform composite assembly or other type of assembly. If a preform composite assembly is to be made, then in a next block 98 one or more of the treated interlayers 36 are alternately disposed in between the reinforcing layers 34. In some embodiments, the treated interlayers 36 and reinforcing layers 34 are built-up to form a stack of composite material 32 which is placed on the preform mold 52. In a next block 100, the preform mold 52 is infused with a matrix material such as resin, epoxy, or other such hardening material. The matrix material saturates each of the layers of the interlayer 36 and reinforcing layer 34. Moreover, in a next block 102, once the stack of composite material 32 is infused with the matrix material the preform mold 52 is placed into a vacuum chamber or other pressure vessel and heated to the cure temperature of the matrix material. The matrix material binds the reinforcing layers 34 and interlayers 36 to form the preform composite laminate structure 50. Moreover, during curing the composite laminate structure 50 is formed into the shape of the supporting mold 52. In some embodiments, the treated interlayers 36 are incorporated within the composite laminate structure 50 to provide improved electrical properties and characteristics, such as increased conductivity, improved EMI shielding, and other such electrical properties. In one non-limiting example, the composite laminate structure 50 with the treated interlayers 36 is capable of dissipating any electric current or charging which results from electric charging or discharging such as, but not limited to, a lightning strike.

Referring back to block 96, if a preform composite is not to be formed using the treated interlayers 36, then in block 104 preparations are made to incorporate the treated interlayer 36 into the composite laminate structure 50 using a different fabrication process, such as a prepreg composite assembly. In prepregging, the treated interlayer 36 is alternately disposed between reinforcing layers 34 to build-up the composite material 32 and the composite material is infused with a matrix material, such as but not limited to a resin, epoxy, or other hardening material. Alternatively, in some embodiments, the interlayer 36 is melt-bonded, to the reinforcing layers 34 prior to infusing the interlayers 36 and reinforcing layers 34 with the matrix material. During melt-bonding, an interlayer 36 is spread out on each side of the reinforcing layers 34. Heat and pressure are introduced such that the interlayers 36 and reinforcing layers 34 are melted, bonded or otherwise attached, such that the interlayers 36 and reinforcing layers 34 do not move with respect to each other.

In a next block 106, the composite material 32 is arranged onto the mold surface and prepared to form a composite laminated structure 50. In a next block 108, the composite material 32 and the prepreg mold are placed under vacuum and heated to a cure temperature of the matrix material such that the composite laminate structure 50 is formed incorporating the one or more of the treated interlayers 36. Similar to the preform composite assembly formed in block 102, the prepreg composite assembly with the treated interlayer 36 provides a composite laminate structure 50 having improved electrical properties, such as increased conductivity, improved EMI shielding and other such electrical properties.

## Claims

1. A method of imparting electrical conductivity on an interlayer (36) material, the method comprising:
forming the interlayer material from at least one layer of a fabric of thermoplastic fibers (44);
treating a surface of the interlayer material using an atmospheric-pressure plasma (66) such that the surface of the interlayer undergoes a surface activation; and
depositing a layer of conductive material (60) on the surface of the interlayer material such that the layer of conductive material increases a conductivity of the interlayer material, the layer of conductive material (60) comprising multiple different metal layers.

2. The method of claim 1, wherein the surface of the interlayer (36) material includes a first side and an opposing second side, wherein the first side and the second side both undergo the surface activation.

3. The method of claims 1 or 2, wherein the surface activation includes treating the interlayer (36) material with an atmospheric-pressure oxygen plasma such that an increased oxygen content is produced on the surface of the interlayer material.

4. The method of any preceding claim, wherein:
a chemical vapor deposition (76) deposits the metal layers on the surface of the interlayer material, and
the chemical vapor deposition is performed at a temperature below a melting point of the interlayer material.

5. The method of any preceding claim, wherein the at least one layer of fabric of thermoplastic fibers (44) comprises at least two different types of thermoplastic fibers.

6. A method of manufacturing a composite material (32) incorporating an interlayer (36) having electrical conductivity, the method comprising:
forming a plurality of interlayers from an interlayer material and treating each interlayer of the plurality of interlayers using an atmospheric-pressure plasma (66) such that a surface of each interlayer of the plurality of interlayers undergoes a surface activation;
depositing a conductive layer (60) on the surface of each interlayer of the plurality of interlayers such that the conductive layer increases a conductivity of the plurality of interlayers, the conductive layer (60) comprising multiple different metal layers;
forming a plurality of reinforcing layers (34) from fibers of a reinforcing material;
disposing the plurality of interlayers each having the conductive layer on the surface alternately between the plurality of reinforcing layers;
coupling the plurality of reinforcing layers and the plurality of interlayers together; and
infusing the plurality of reinforcing layers and the plurality of interlayers with a matrix material, and curing the matrix material such that conductivity of the plurality of interlayers improves an electrical conductivity of the composite material.

7. The method of claim 6, wherein the surface of each interlayer (36) of the plurality of interlayers includes a first side and an opposing second side, wherein the first side and the second side both undergo the surface activation.

8. The method of claims 6 or 7, wherein the surface activation includes treating each interlayer (36) of the plurality of interlayers with an atmospheric-pressure oxygen plasma such that an increased oxygen content is produced on the surface of each interlayer of the plurality of interlayers.

9. The method of any of claims 6 to 8, wherein a chemical vapor deposition (76) deposits the metal layers on the surface of each interlayer of the plurality of interlayers, and wherein the chemical vapor deposition is performed at a temperature below a melting point of each interlayer of the plurality of interlayers.

10. The method of any of claims 6 to 9, wherein each interlayer (36) of the plurality of interlayers comprises a layer of non-woven fabric of thermoplastic fibers (44) having at least two different types of thermoplastic fibers.

11. A composite material having electrical conductivity, the composite material comprising:
a plurality of interlayers each formed from a layer of fabric of thermoplastic fibers;
a surface of each interlayer of the plurality of interlayers that has been treated using an atmospheric-pressure plasma such that the surface of each interlayer of the plurality of interlayers underwent a surface activation;
a conductive layer deposited on the surface of each interlayer of the plurality of interlayers such that the conductive layer increases a conductivity of each interlayer of the plurality of interlayers, the conductive layer comprising multiple different metal layers;
a plurality of reinforcing layers formed from fibers of reinforcing material, wherein each interlayer of the plurality of interlayers having the conductive layer on the surface is alternately disposed between the plurality of reinforcing layers, wherein the plurality of reinforcing layers are coupled together with the plurality of interlayers; and
a matrix material infused into the plurality of reinforcing layers and the plurality of interlayers, wherein the matrix material has been cured such that the conductivity of the plurality of interlayers improves an electrical conductivity of the composite material.

12. The composite material of claim 11, wherein the plurality of interlayers include a first side and an opposing second side, wherein the first side and the second side both underwent the surface activation.

13. The composite material of claim 11 or 12, wherein the surface activation included each interlayer of the plurality of interlayers being treated with an atmospheric-pressure oxygen plasma such that an increased oxygen content is produced on the surface of each interlayer of the plurality of interlayers.

14. The composite material of any of claims 11-13, wherein the metal layers on the surface of each interlayer of the plurality of interlayers was deposited by chemical vapour deposition and the chemical vapor deposition was performed at a temperature below a melting point of each interlayer of the plurality of interlayers.

15. The composite material of any of claims 11-14, wherein each interlayer of the plurality of interlayers comprises a layer of non-woven fabric of thermoplastic fibers having at least two different types of thermoplastic fibers.

## Patentansprüche

1. Verfahren zum elektrisch Leitfähigmachen eines Zwischenschichtmaterials (36), wobei das Verfahren umfasst:
Bilden des Zwischenschichtmaterials aus mindestens einer Schicht eines Gewebes aus thermoplastischen Fasern (44);
Behandeln einer Oberfläche des Zwischenschichtmaterials unter Verwendung eines Atmosphärendruckplasmas (66), so dass die Oberfläche der Zwischenschicht eine Oberflächenaktivierung erfährt; und
Abscheiden einer Schicht aus leitfähigem Material (60) auf der Oberfläche des Zwischenschichtmaterials, so dass die Schicht aus leitfähigem Material eine Leitfähigkeit des Zwischenschichtmaterials erhöht, wobei die Schicht aus leitfähigem Material (60) mehrere verschiedene Metallschichten umfasst.

2. Verfahren nach Anspruch 1, bei dem die Oberfläche des Zwischenschichtmaterials (36) eine erste Seite und eine gegenüberliegende zweite Seite aufweist, und sowohl die erste Seite als auch die zweite Seite die Oberflächenaktivierung erfahren.

3. Verfahren nach Anspruch 1 oder 2, bei dem die Oberflächenaktivierung die Behandlung des Zwischenschichtmaterials (36) mit einem Atmosphärendruck-Sauerstoffplasma umfasst, so dass ein erhöhter Sauerstoffgehalt auf der Oberfläche des Zwischenschichtmaterials erzeugt wird.

4. Verfahren nach einem der vorhergehenden Ansprüche, bei dem
eine chemische Gasphasenabscheidung (76) die Metallschichten auf der Oberfläche des Zwischenschichtmaterials abscheidet, und
die chemische Gasphasenabscheidung bei einer Temperatur unterhalb eines Schmelzpunktes des Zwischenschichtmaterials durchgeführt wird.

5. Verfahren nach einem der vorhergehenden Ansprüche, bei dem die mindestens eine Gewebeschicht aus thermoplastischen Fasern (44) mindestens zwei verschiedene Arten von thermoplastischen Fasern umfasst.

6. Verfahren zur Herstellung eines Verbundmaterials (32), das eine Zwischenschicht (36) mit elektrischer Leitfähigkeit enthält, wobei das Verfahren umfasst:
Bilden einer Mehrzahl von Zwischenschichten aus einem Zwischenschichtmaterial und Behandeln jeder Zwischenschicht der Mehrzahl von Zwischenschichten unter Verwendung eines Atmosphärendruckplasmas (66), so dass eine Oberfläche jeder Zwischenschicht der Mehrzahl von Zwischenschichten eine Oberflächenaktivierung erfährt;
Abscheiden einer leitfähigen Schicht (60) auf der Oberfläche jeder Zwischenschicht der Mehrzahl von Zwischenschichten, so dass die leitfähige Schicht eine Leitfähigkeit der Mehrzahl von Zwischenschichten erhöht, wobei die leitfähige Schicht (60) mehrere verschiedene Metallschichten umfasst;
Bilden einer Mehrzahl von Verstärkungsschichten (34) aus Fasern eines Verstärkungsmaterials;
Anordnen der Mehrzahl von Zwischenschichten, die jeweils die leitfähige Schicht auf der Oberfläche aufweisen, abwechselnd zwischen der Mehrzahl von Verstärkungsschichten;
Verbinden der Mehrzahl von Verstärkungsschichten und der Mehrzahl von Zwischenschichten miteinander; und
Infundieren der Mehrzahl von Verstärkungsschichten und der Mehrzahl von Zwischenschichten mit einem Matrixmaterial und Aushärten des Matrixmaterials, so dass die Leitfähigkeit der Mehrzahl von Zwischenschichten eine elektrische Leitfähigkeit des Verbundmaterials verbessert.

7. Verfahren nach Anspruch 6, bei dem die Oberfläche jeder Zwischenschicht (36) der Mehrzahl von Zwischenschichten eine erste Seite und eine gegenüberliegende zweite Seite aufweist, wobei sowohl die erste Seite als auch die zweite Seite die Oberflächenaktivierung erfahren.

8. Verfahren nach Anspruch 6 oder 7, bei dem die Oberflächenaktivierung die Behandlung jeder Zwischenschicht (36) der Mehrzahl von Zwischenschichten mit einem Atmosphärendruck-Sauerstoffplasma umfasst, so dass ein erhöhter Sauerstoffgehalt auf der Oberfläche jeder Zwischenschicht der Mehrzahl von Zwischenschichten erzeugt wird.

9. Verfahren nach einem der Ansprüche 6 bis 8, bei dem eine chemische Gasphasenabscheidung (76) die Metallschichten auf der Oberfläche jeder Zwischenschicht der Mehrzahl von Zwischenschichten abscheidet, und bei dem die chemische Gasphasenabscheidung bei einer Temperatur unterhalb eines Schmelzpunktes jeder Zwischenschicht der Mehrzahl von Zwischenschichten durchgeführt wird.

10. Verfahren nach einem der Ansprüche 6 bis 9, bei dem jede Zwischenschicht (36) der Mehrzahl von Zwischenschichten eine Schicht aus Vliesstoff aus thermoplastischen Fasern (44) umfasst, die mindestens zwei verschiedene Arten von thermoplastischen Fasern aufweist.

11. Verbundmaterial mit elektrischer Leitfähigkeit, wobei das Verbundmaterial umfasst:
eine Mehrzahl von Zwischenschichten, die jeweils aus einer Schicht eines Gewebes aus thermoplastischen Fasern gebildet sind;
eine Oberfläche jeder Zwischenschicht der Mehrzahl von Zwischenschichten, die unter Verwendung eines Atmosphärendruckplasmas behandelt wurde, so dass die Oberfläche jeder Zwischenschicht der Mehrzahl von Zwischenschichten einer Oberflächenaktivierung unterzogen wurde;
eine leitfähige Schicht, die auf der Oberfläche jeder Zwischenschicht der Mehrzahl von Zwischenschichten so abgeschieden ist, dass die leitfähige Schicht eine Leitfähigkeit jeder Zwischenschicht der Mehrzahl von Zwischenschichten erhöht, wobei die leitfähige Schicht mehrere unterschiedliche Metallschichten umfasst;
eine Mehrzahl von Verstärkungsschichten, die aus Fasern aus Verstärkungsmaterial gebildet sind, wobei jede Zwischenschicht der Mehrzahl von Zwischenschichten mit der leitfähigen Schicht auf der Oberfläche abwechselnd zwischen der Mehrzahl von Verstärkungsschichten angeordnet ist, und die Mehrzahl von Verstärkungsschichten mit der Mehrzahl von Zwischenschichten zusammengekoppelt sind; und
ein Matrixmaterial, das in die Mehrzahl von Verstärkungsschichten und die Mehrzahl von Zwischenschichten infundiert ist, wobei das Matrixmaterial so ausgehärtet ist, dass die Leitfähigkeit der Mehrzahl von Zwischenschichten eine elektrische Leitfähigkeit des Verbundmaterials verbessert.

12. Verbundmaterial nach Anspruch 11, bei dem die Mehrzahl von Zwischenschichten eine erste Seite und eine gegenüberliegende zweite Seite aufweist, wobei sowohl die erste Seite als auch die zweite Seite der Oberflächenaktivierung unterzogen wurden.

13. Verbundmaterial nach Anspruch 11 oder 12, bei dem die Oberflächenaktivierung beinhaltet, dass jede Zwischenschicht der Mehrzahl von Zwischenschichten mit einem Atmosphärendruck-Sauerstoffplasma behandelt wird, so dass ein erhöhter Sauerstoffgehalt auf der Oberfläche jeder Zwischenschicht der Mehrzahl von Zwischenschichten erzeugt wird.

14. Verbundmaterial nach einem der Ansprüche 11-13, bei dem die Metallschichten auf der Oberfläche jeder Zwischenschicht der Mehrzahl von Zwischenschichten durch chemische Gasphasenabscheidung abgeschieden wurden und die chemische Gasphasenabscheidung bei einer Temperatur unterhalb des Schmelzpunkts jeder Zwischenschicht der Mehrzahl von Zwischenschichten durchgeführt wurde.

15. Verbundmaterial nach einem der Ansprüche 11-14, bei dem jede Zwischenschicht der Mehrzahl von Zwischenschichten eine Schicht aus einem Vlies aus thermoplastischen Fasern umfasst, die mindestens zwei verschiedene Arten von thermoplastischen Fasern aufweist.

## Revendications

1. Procédé pour conférer une conductivité électrique sur un matériau de couche intermédiaire (36), le procédé comprenant les étapes consistant à :
former le matériau de couche intermédiaire à partir d'au moins une couche d'un tissu de fibres thermoplastiques (44) ;
traiter une surface du matériau de couche intermédiaire en utilisant un plasma à pression atmosphérique (66) de telle sorte que la surface de la couche intermédiaire subit une activation de surface ; et
déposer une couche de matériau conducteur (60) sur la surface du matériau de couche intermédiaire de sorte que la couche de matériau conducteur augmente une conductivité du matériau de couche intermédiaire, la couche de matériau conducteur (60) comprenant de multiples couches de métal différentes.

2. Procédé selon la revendication 1, dans lequel la surface du matériau de couche intermédiaire (36) comprend un premier côté et un second côté opposé, dans lequel le premier côté et le second côté subissent tous les deux l'activation de surface.

3. Procédé selon les revendications 1 ou 2, dans lequel l'activation de surface comprend le traitement du matériau de couche intermédiaire (36) avec un plasma d'oxygène à pression atmosphérique de telle sorte qu'une teneur en oxygène accrue est produite sur la surface du matériau de couche intermédiaire.

4. Procédé selon l'une quelconque des revendications précédentes, dans lequel :
un dépôt chimique en phase vapeur (76) dépose les couches de métal sur la surface du matériau de couche intermédiaire, et
le dépôt chimique en phase vapeur est effectué à une température inférieure à un point de fusion du matériau de couche intermédiaire.

5. Procédé selon l'une quelconque des revendications précédentes, dans lequel la au moins une couche de tissu de fibres thermoplastiques (44) comprend au moins deux types différents de fibres thermoplastiques.

6. Procédé de fabrication d'un matériau composite (32) incorporant une couche intermédiaire (36) ayant une conductivité électrique, le procédé comprenant les étapes consistant à :
former une pluralité de couches intermédiaires à partir d'un matériau de couche intermédiaire et traiter chaque couche intermédiaire de la pluralité de couches intermédiaires en utilisant un plasma à pression atmosphérique (66) de telle sorte qu'une surface de chaque couche intermédiaire de la pluralité de couches intermédiaires subit une activation de surface ;
déposer une couche conductrice (60) sur la surface de chaque couche intermédiaire de la pluralité de couches intermédiaires de telle sorte que la couche conductrice augmente une conductivité de la pluralité de couches intermédiaires, la couche conductrice (60) comprenant de multiples couches de métal différentes ;
former une pluralité de couches de renforcement (34) à partir de fibres d'un matériau de renforcement ;
disposer la pluralité de couches intermédiaires ayant chacune la couche conductrice sur la surface alternativement entre la pluralité de couches de renforcement ;
coupler la pluralité de couches de renforcement et la pluralité de couches intermédiaires ensemble ; et
perfuser la pluralité de couches de renforcement et la pluralité de couches intermédiaires avec un matériau de matrice, et durcir le matériau de matrice de telle sorte que la conductivité de la pluralité de couches intermédiaires améliore une conductivité électrique du matériau composite.

7. Procédé selon la revendication 6, dans lequel la surface de chaque couche intermédiaire (36) de la pluralité de couches intermédiaires comprend un premier côté et un second côté opposé, dans lequel le premier côté et le second côté subissent tous les deux l'activation de surface.

8. Procédé selon la revendication 6 ou 7, dans lequel l'activation de surface comprend le traitement de chaque couche intermédiaire (36) de la pluralité de couches intermédiaires avec un plasma d'oxygène à pression atmosphérique de telle sorte qu'une teneur en oxygène accrue est produite sur la surface de chaque couche intermédiaire de la pluralité de couches intermédiaires.

9. Procédé selon l'une quelconque des revendications 6 à 8, dans lequel un dépôt chimique en phase vapeur (76) dépose les couches métalliques sur la surface de chaque couche intermédiaire de la pluralité de couches intermédiaires, et dans lequel le dépôt chimique en phase vapeur est effectué à une température inférieure à un point de fusion de chaque couche intermédiaire de la pluralité de couches intermédiaires.

10. Procédé selon l'une quelconque des revendications 6 à 9, dans lequel chaque couche intermédiaire (36) de la pluralité de couches intermédiaires comprend une couche de tissu non tissé de fibres thermoplastiques (44) ayant au moins deux types différents de fibres thermoplastiques.

11. Matériau composite ayant une conductivité électrique, le matériau composite comprenant :
une pluralité de couches intermédiaires formées chacune à partir d'une couche de tissu de fibres thermoplastiques ;
une surface de chaque couche intermédiaire de la pluralité de couches intermédiaires qui a été traitée en utilisant un plasma à pression atmosphérique de telle sorte que la surface de chaque couche intermédiaire de la pluralité de couches intermédiaires a subi une activation de surface ;
une couche conductrice déposée sur la surface de chaque couche intermédiaire de la pluralité de couches intermédiaires de telle sorte que la couche conductrice augmente une conductivité de chaque couche intermédiaire de la pluralité de couches intermédiaires, la couche conductrice comprenant de multiples couches de métal différentes ;
une pluralité de couches de renforcement formées à partir de fibres de matériau de renforcement, dans lequel chaque couche intermédiaire de la pluralité de couches intermédiaires ayant la couche conductrice sur la surface est disposée alternativement entre la pluralité de couches de renforcement, dans lequel la pluralité de couches de renforcement sont couplées ensemble avec la pluralité de couches intermédiaires ; et
un matériau de matrice perfusé dans la pluralité de couches de renforcement et la pluralité de couches intermédiaires, dans lequel le matériau de matrice a été durci de telle sorte que la conductivité de la pluralité de couches intermédiaires augmente une conductivité électrique du matériau composite.

12. Matériau composite selon la revendication 11, dans lequel la pluralité de couches intermédiaires comprend un premier côté et un second côté opposé, dans lequel le premier côté et le second côté subissent tous les deux l'activation de surface.

13. Matériau composite selon la revendication 11 ou 12, dans lequel l'activation de surface comprend chaque couche intermédiaire de la pluralité de couches intermédiaires étant traitée avec un plasma d'oxygène à pression atmosphérique de telle sorte qu'une teneur en oxygène accrue soit produite sur la surface de chaque couche intermédiaire de la pluralité de couches intermédiaires.

14. Matériau composite selon l'une quelconque des revendications 11 à 13, dans lequel les couches métalliques sur la surface de chaque couche intermédiaire de la pluralité de couches intermédiaires ont été déposées par dépôt chimique en phase vapeur et le dépôt chimique en phase vapeur a été effectué à une température inférieure à un point de fusion de chaque couche intermédiaire de la pluralité de couches intermédiaires.

15. Matériau composite l'une quelconque des revendications 11 à 14, dans lequel chaque couche intermédiaire de la pluralité de couches intermédiaires comprend une couche de tissu non tissé de fibres thermoplastiques ayant au moins deux types différents de fibres thermoplastiques.
